# FASCICULE DE BREVET EUROPEEN

(11) **EP 2 355 637 B1**
(45) Date de publication et mention de la délivrance du brevet: **23.01.2019**
(21) Numéro de dépôt: 11153451.7
(22) Date de dépôt: 04.02.2011
(51) Int. Cl.: H05K 7/14

(54) **Ensemble de connexion à câblage frontal d'au moins un équipement électronique dans un aéronef**
Anschlusseinheit mit Frontalverkabelung mindestens einer elektronischen Ausrüstung in einem Luftfahrzeug
Frontal cabling connection unit of at least one electronic device in an aircraft

(30) Priorité: 05.02.2010 FR 1050838
(43) Date de publication de la demande: 10.08.2011
(73) Titulaire: Airbus Operations, 31060 Toulouse (FR)
(72) Inventeur: Colongo, Emile, 31310, Montesquieu Volvestre (FR); Salles, Pierre, 31880, La Salvetat St Gilles (FR)
(74) Mandataire: Santarelli

(56) Documents cités:
- EP-A1- 1 793 659
- FR-A1- 2 822 130
- FR-A1- 2 927 222
- US-A1- 2003 081 386
- US-B1- 6 489 565

## Description

La présente invention concerne un ensemble de connexion d'au moins un équipement électronique dans un aéronef.

Dans un aéronef, de nombreux équipements électroniques sont localisés dans une zone située sous le cockpit de l'aéronef, qui offre aux équipements des conditions environnementales privilégiées telles qu'une pression ambiante raisonnable et une température ambiante maîtrisée. Des moyens de support sont disposés dans cette zone et permettent de fixer les équipements, de les connecter aux câbles de l'aéronef et de les ventiler.

Le document US2004050569 décrit et représente un ensemble de connexion connu, dans lequel au moins un équipement électronique est disposé dans un moyen de support. Ce moyen de support est rapporté sur une structure porteuse mobile. La structure porteuse comprend une interface de connexion sur laquelle vient se connecter le moyen de support. L'ensemble ainsi formé est amené dans la zone souhaitée, à côté d'autres ensembles formés séparément et le câblage de l'aéronef est rapporté sur chaque interface de connexion solidaire d'un moyen de support.

Le document FR 2 927 222 décrit un arrangement de rack d'appareillages électroniques dans un avion. La structure du rack est composée de cabinets abritant à la fois des modules de fonction recevant des appareillages électriques et des modules d'interfaces. Les modules d'interface assurent, à travers le cabinet. la connexion à la carte mère disposée dans les modules de fonction.

Le document EP 1 793 659 divulgue une armoire électrique comportant un support de câblage. Ce support comporte des éléments de support croisés dans lesquels des faisceaux de câbles sont regroupés.

L'invention vise à proposer un ensemble de connexion d'un équipement électronique simplifié par rapport à l'art antérieur, notamment dans les opérations d'installation, de câblage, et de manutention ultérieure de l'ensemble électronique.

A cet effet, l'invention a pour objet un ensemble de connexion d'au moins un équipement électronique au câblage d'un aéronef, dans lequel ledit au moins un équipement électronique est disposé dans un moyen de support et comporte des moyens de connexion aptes à être raccordés au câblage de l'aéronef par l'intermédiaire d'au moins une interface de connexion ladite au moins une interface de connexion étant raccordée au câblage par l'intermédiaire d'un boîtier de câblage interposé entre ladite interface et le câblage, ledit boîtier de câblage étant disposé dans le moyen de support pour assurer la connexion entre l'interface de connexion et le câblage à travers ledit moyen de support, le moyen de support comportant une face avant et une face arrière au niveau de laquelle est disposée ladite au moins une interface de connexion, caractérisée en ce que l'ensemble de connexion repose sur une surface et comporte un caisson dans lequel est disposé le câblage et qui s'étend au voisinage de la face avant du moyen de support, le caisson étant disposé au-dessus d'une ouverture pratiquée dans ladite surface et le câblage traversant l'ouverture pour pénétrer dans le caisson, en ce que ladite au moins une interface de connexion est fixée à la structure de l'aéronef, et en ce que des moyens de guidage sont disposés sur la structure de l'aéronef pour guider le moyen de support en regard de l'interface de connexion.

Un tel ensemble de connexion permet avantageusement de réduire l'encombrement du câblage de l'aéronef du fait de l'intégration d'une partie de ce câblage dans des modules incorporés dans le moyen de support. Il permet un aménagement simplifié des zones de l'aéronef dans lesquelles des équipements électroniques doivent être raccordés au câblage.

En outre, la présence d'un passage de câbles en face avant du moyen de support permet notamment de protéger les câbles lors d'éventuelles manipulations par un opérateur et d'éviter que ce dernier ne trébuche sur le câblage. En effet, les abords de cette face avant sont susceptibles d'être plus fréquentés lors des manipulations. Le fait de rassembler les câbles offre également un gain de place non négligeable, ce qui est utile en face avant du moyen de support. Enfin, le passage de câbles permet de dissimuler les câbles ce qui, d'un point de vue esthétique, est appréciable.

Cette disposition en face avant rend la connexion du câblage de l'aéronef plus simple à réaliser et à contrôler (grâce à une visualisation des connexions). Par ailleurs, d'éventuelles modifications à apporter à la connexion, voire au câblage lui-même, sont plus simples à effectuer. Selon différentes caractéristiques :
- Le moyen de support comporte au moins un module de section sensiblement rectangulaire, dont le fond est en regard de l'interface de connexion, et dont la face avant est ouverte, ledit au moins un équipement électronique et le boîtier de câblage étant adaptés pour être insérés dans ledit au moins un module.
- Ledit au moins un module est adapté pour recevoir au moins un équipement électronique et un unique boîtier de câblage.
- Le boîtier de câblage est raccordé par une extrémité au câblage de l'aéronef au voisinage de la face avant dudit au moins un module, l'extrémité opposée dudit boîtier de câblage étant connectée dans le fond dudit au moins un module à ladite au moins une interface de connexion.
- Le moyen de support comporte plusieurs modules disposés les uns au dessus des autres.
- Ladite au moins une interface de connexion est intégrée au moyen de support.
- Deux moyens de support sont disposés côte à côte, un unique passage de câbles s'étendant au voisinage des deux moyens de support.
- Le meuble présente un système de refroidissement intégré ; le système de refroidissement du meuble est autonome, ou interconnecté avec le réseau de refroidissement de l'aéronef.
- Ladite au moins une interface de connexion s'étend sensiblement verticalement le long de la structure de l'aéronef.
- Le passage de câbles comprend un caisson dans lequel est disposé le câblage.
- Le câblage est disposé à la verticale, le caisson s'étendant verticalement.
- Le caisson est pourvu de trous disposés de façon à ce que les câbles ou faisceaux de câbles constituant le câblage ressortent du caisson à travers les trous en vue de leur raccordement à un ou plusieurs boîtiers de câblage disposés sensiblement au voisinage des trous.
- Le caisson est disposé au-dessus d'une ouverture pratiquée dans une surface (par exemple le plancher) sur laquelle repose l'ensemble de connexion. Le câblage de l'aéronef traverse ainsi l'ouverture pour pénétrer dans le caisson.
- Des moyens de guidage sont disposés sur la structure de l'aéronef, pour guider le moyen de support en regard de l'interface de connexion.

L'invention porte également sur un aéronef comportant au moins un ensemble de connexion d'un équipement électronique selon l'invention.

Les caractéristiques et avantages de l'invention ressortiront de la description qui suit, donnée à titre d'exemple préféré, mais non limitatif, en référence aux dessins annexés, sur lesquels :
- la figure 1 est une représentation d'un ensemble de connexion selon l'invention;
- la figure 2 est une représentation schématique du moyen de support, vue de trois quart arrière, dans un mode de réalisation utile à la compréhension de l'invention mais qui n'en fait pas partie ;
- la figure 3 est une représentation de l'ensemble de connexion de la figure 1, dans une position alternative dans laquelle le moyen de support est en retrait par rapport à la structure de l'aéronef;

L'ensemble de connexion 1 d'un équipement électronique 2 comporte au moins un moyen de support 4 et une interface de connexion 6. L'ensemble de connexion 1 est disposé dans un aéronef, et assure le raccordement de l'équipement électronique 2 au câblage 3 de l'aéronef.

Le moyen de support 4 forme en quelque sorte un meuble qui comporte des modules 8 de section sensiblement rectangulaire. Chaque meuble 4 comporte par exemple une étagère inférieure 10, une étagère intermédiaire 11 et une étagère supérieure 12, reliées par deux parois latérales 14, qui délimitent ainsi une face avant 16 et une face arrière 18. La face avant et la face arrière de chaque module sont ouvertes, sans parois pour faciliter l'accès et les manipulations.

Tel qu'illustré, trois modules 8 sont ici empilés les uns sur les autres, pour former un moyen de support 4 de hauteur déterminée. En outre, ici, deux moyens de support 4 sont disposés côte à côte. Les six modules 8 ont les mêmes dimensions et sont alignés, de sorte que chaque face arrière 18 est comprise dans un même plan vertical.

On notera que chaque moyen de support 4 peut comprendre un nombre de modules différent de trois et plus de deux moyens peuvent être disposés de façon adjacente.

Des moyens formant glissière 20 sont aménagés sur les faces en vis-à-vis de l'étagère inférieure 10 de l'étagère intermédiaire 11 et de l'étagère supérieure 12 d'un même module 8.

Chaque module 8 est adapté pour recevoir au moins un équipement électronique 2 et un boîtier de câblage 30. L'équipement électronique 2 et le boîtier de câblage 30 de chaque module 8 sont disposés par exemple verticalement sur chacune des étagères inférieure 10, intermédiaire 11 et supérieure 12 dudit meuble 4.

L'équipement électronique 2 comporte un capot 22 de protection. Le capot comporte des nervures 24 formant des moyens de guidage complémentaires adaptés pour coopérer avec les moyens formant glissières 20 aménagés sur les faces en vis-à-vis des étagères du moyen de support 4. Lesdites nervures 24 s'étendent axialement sur une face supérieure et une face inférieure du capot 22.

L'équipement électronique 2 comporte en outre, sur une face de son capot 22 perpendiculaire à ses faces supérieure et inférieure et perpendiculaire à la direction axiale d'extension des nervures, des premiers moyens de connexion. Lorsque chaque équipement électronique 2 est inséré dans un module 8 du moyen de support 4, lesdits premiers moyens de connexion de chaque équipement électronique débouchent sur la face arrière 18 dudit module 8.

Le boîtier de câblage 30 comporte un capot de protection qui présente des dimensions équivalentes aux dimensions du capot 22 de l'équipement électronique 2. Le boîtier de câblage 30 comporte des moyens de guidage complémentaires (non visibles sur les figures) adaptés à coopérer avec les moyens formant glissières 20 aménagés sur les faces en vis-à-vis des étagères du moyen de support 4. Deux faces opposées dites avant et arrière de ce boîtier de câblage comportent des moyens de raccordement du câblage 32, de sorte que lorsque le boîtier de câblage 30 est inséré dans un module 8 du moyen de support 4, lesdits moyens de raccordement de câblage débouchent sur la face avant 16 et sur la face arrière 18 dudit module 8.

Les faces avant et arrière opposées du boîtier de câblage 30 sont agencées perpendiculairement à la direction d'insertion du boîtier dans le module et perpendiculairement aux faces du boîtier qui comportent les moyens de guidage complémentaires.

Au moins une interface de connexion 6 est prévue pour le raccordement du câblage de l'aéronef aux premiers moyens de connexion des équipements électroniques 2 portés par les modules 8 du moyen de support 4.

Il est par exemple envisageable de disposer d'une interface de connexion par module. Alternativement, une interface pourrait être commune à plusieurs modules.

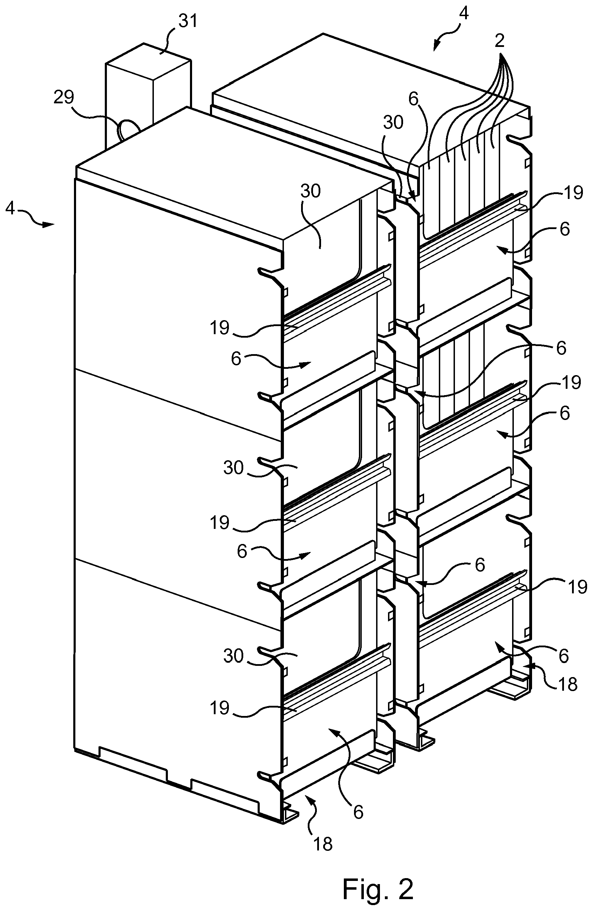

Une telle interface de connexion est par exemple réalisée sous la forme d'une carte électronique, sensiblement plane, montée au niveau de la face arrière 18 du meuble (Figure 2), dans un mode de réalisation utile à la compréhension de l'invention mais qui n'en fait pas partie.

L'interface a par exemple une forme en L qui est adaptée à l'agencement du boîtier de câblage 30 et des équipements électroniques 2 dans chaque module. Dans la mesure où il y a un plus grand nombre de points de connexion/câblage entre le boîtier de câblage 30 et l'interface qu'entre les équipements électroniques et l'interface, cette dernière s'étend suivant sensiblement toute la dimension de la face arrière du boîtier de câblage mais pas suivant toute la face arrière des équipements électroniques 2.

C'est pourquoi l'interface n'arrive qu'à mi-hauteur de cette face arrière comme représenté sur la Figure 2. En outre, cet agencement de l'interface réduit le poids de l'ensemble.

Ainsi, l'interface a une forme en L dont la branche verticale est en regard de la face arrière du boîtier de câblage 30, tandis que la branche horizontale est en regard d'une partie seulement de la face arrière des équipements électroniques 2. D'autres formes d'interface sont envisageables selon l'agencement des éléments dans les modules 8, en fonction des nécessités de connexion et des éléments (nature, forme, nombre ...).

Chaque interface de connexion 6 est positionnée sensiblement au droit de la face arrière 18 des modules 8 (elle est solidaire de chaque module 8), et présente des deuxièmes moyens de connexion (non représentés sur la Figure 2 car ils sont orientés vers l'intérieur de chaque module) qui sont en partie adaptés pour être connectés aux premiers moyens de connexion portés par les équipements électroniques 2. Une deuxième partie de ces deuxièmes moyens de connexion est également adaptée pour être connectée aux moyens de raccordement de câblage 32 (connecteurs) du boîtier de câblage 30 qui sont agencés sur la face arrière de ce dernier. Cela correspond à un mode de réalisation utile à la compréhension de l'invention mais qui n'en fait pas partie.

Selon une variante non représentée, l'interface de connexion 6 est fixée à la structure 28 de l'aéronef.

Comme illustré, le moyen de support 4 comporte deux bords latéraux verticaux 41 formés par les parois latérales respectives des modules 8 superposés, et un bord supérieur horizontal 42 formé par l'étagère supérieure du module disposé au sommet du moyen de support 4.

Un passage ou guide de câbles 31 est formé d'un caisson dans lequel sont disposés des câbles ou faisceaux de câbles 3 de l'aéronef. Ici, le passage de câbles 31 s'étend verticalement, le long d'un bord latéral vertical 41 du moyen de support 4. En variante, ledit passage de câbles 31 s'étend horizontalement le long du bord supérieur horizontal 42 du moyen de support. Selon d'autres variantes, le caisson horizontal est fixé à une paroi verticale de l'aéronef d'où sort le câblage, ou est raccordé à un autre caisson vertical qui est muni d'une ouverture interne au niveau du raccordement de sorte à former un caisson global en forme de L inversé. Dans tous les cas, le passage de câbles 31 s'étend au voisinage de la face avant 16 du moyen de support 4, ledit passage de câbles 31 étant raccordé au boîtier de câblage 30 à proximité de cette face avant 16 du moyen de support 4.

On va maintenant décrire la mise en place et l'utilisation d'un tel ensemble de connexion.

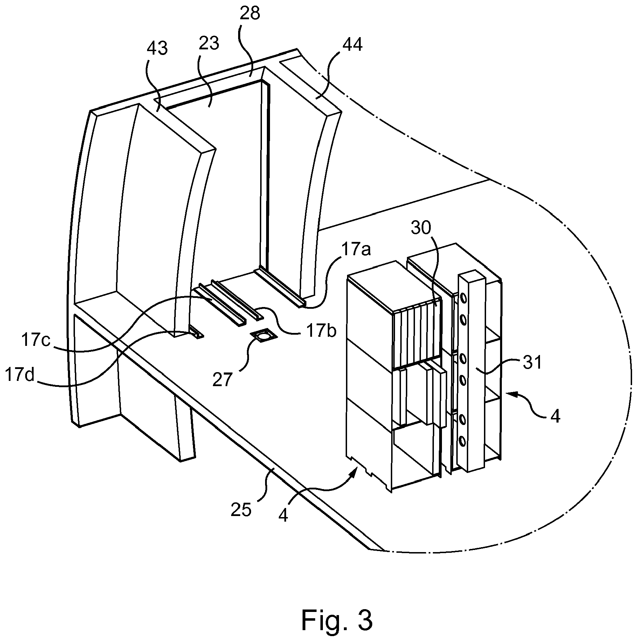

Préalablement, un montant vertical 23 est fixé contre la structure 28 de l'aéronef et des rails de guidage 17a, 17b, 17c, 17d, (soit deux paires, une paire pour chaque meuble) sont fixés au plancher 25 de l'aéronef, perpendiculairement au montant 23 (Figure 3).

Une interface de connexion 6 est installée dans chaque module 8 d'un premier moyen de support 4 (premier meuble) au niveau de la face arrière 18 et des raidisseurs 19 sont montés entre les parois latérales des modules. Les trois modules 8 sont montés les uns au-dessus des autres.

Le premier moyen de support 4 est amené contre le montant 23 de la structure 28 de l'aéronef, à proximité d'une ouverture 27 pratiquée dans le plancher 25 pour permettre la traversée de câbles du câblage de l'aéronef et est, par exemple, rendu solidaire de la structure 28. Lors de cette mise en place du premier moyen de support, l'équipement électronique 2 et le boîtier de câblage 30 sont déjà en place dans le moyen de support 4. En variante, le moyen de support est amené contre la structure 28, et les équipements électroniques et les boîtiers de câblage sont insérés après dans le moyen de support.

On notera dans ces deux cas que l'établissement des connexions, d'une part, entre les équipements électroniques 2 et l'interface de connexion 6 et, d'autre part, entre le boîtier de câblage 30 et l'interface de connexion 6 peut être réalisée très simplement « en aveugle » : on insère chacune des unités 2 et 30 à l'intérieur d'un module jusqu'à venir en contact au fond avec l'interface, emboîtant ainsi les connecteurs mâles de l'un des éléments avec les connecteurs femelles de l'autre élément. On réalise ainsi simplement de cette façon l'établissement des connexions électriques.

On notera qu'un verrouillage mécanique des unités avec l'interface peut être également effectué.

Le premier moyen de support 4 peut comporter des moyens aptes à faciliter son déplacement, non représentés, comme des roulettes, ou des moyens de prise pour un appareil de manutention.

Le guidage en translation est facilité par la présence de moyens de guidage disposés au voisinage de la structure 28. Comme illustré, ces moyens de guidage sont ici des parois verticales 43, 44, solidaires de la structure 28 de l'aéronef et qui s'étendant perpendiculairement vers l'intérieur de l'aéronef à partir de cette structure. Ces parois encadrent le montant 23.

Le premier moyen de support 4 est disposé selon une première direction entre la structure latérale 28 de l'aéronef et le passage de câbles 31 et selon une deuxième direction perpendiculaire entre ledit passage de câbles 31 et une première paroi 43 de la structure 28.

Un deuxième moyen de support 4 (deuxième meuble) est amené de façon similaire contre le montant 23 de la structure 28. Le deuxième moyen de support est disposé selon une première direction entre la structure latérale 28 et le passage de câbles 31, et selon une deuxième direction perpendiculaire, entre ledit passage de câbles 31 et une deuxième paroi 44 de la structure 28.

Les deux moyens de support 4 sont ici positionnés côte à côte de sorte que le passage de câbles 31 s'étend au voisinage de la face avant de chaque moyen de support et par exemple, plus précisément, au voisinage d'un bord latéral vertical 41.

Le caisson 31, également appelé fourreau, est mis en place au dessus de l'ouverture 27 et les faisceaux de câbles 3 traversants sont installés à l'intérieur du caisson et sont positionnés de façon appropriée au niveau des différents trous 29 prévus dans le caisson pour ressortir dudit caisson à travers ceux-ci en vue de leur raccordement.

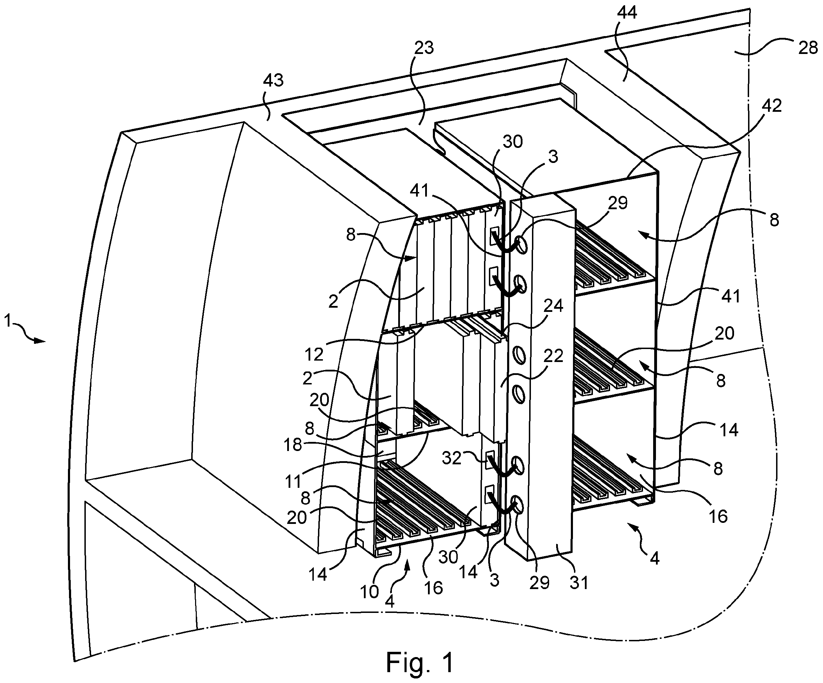

Les trous sont pratiqués par exemple sur sensiblement toute la hauteur du caisson (ou alternativement selon une partie de la hauteur) afin de distribuer les faisceaux de câbles à différentes hauteurs pour différents modules 8. Les trous 29 sont par exemple réalisés sur deux faces opposées du caisson dont seule une face est visible sur les figures 1 et 3.

Alternativement, des trous pourraient être pratiqués sur chaque face pour faciliter l'installation du caisson sur le plancher.

Dès lors les faisceaux de câbles munis de leurs connecteurs débouchent en dehors des trous du caisson et pendent le long de celui-ci, prêts pour le raccordement.

On raccorde alors les faisceaux de câbles 3 du passage de câbles 31 à une première extrémité (face avant) d'au moins un boîtier de câblage 30, par l'intermédiaire des moyens de raccordement au câblage 32 (connecteurs) portés par cette première extrémité et qui débouchent sur la face avant 16 du module 8 (Figure 1).

L'autre extrémité (face arrière) de ce boîtier de câblage 30 étant connectée à l'interface de connexion 6, on réalise ainsi une connexion des équipements électroniques 2 au câblage 3 de l'aéronef par l'intermédiaire, successivement, d'une interface de connexion 6 et d'un boîtier de câblage 30.

Par ailleurs, dans l'exemple un guide de câbles est commun à deux meubles et, alternativement, pourrait être utilisé avec plus de deux meubles selon la forme, et les dimensions du guide de câbles et selon la disposition de ce dernier par rapport aux meubles.

On notera que les boîtiers de câblage 30 sont disposés dans le moyen de support 4, de sorte que la connexion entre l'interface de connexion 6 et le câblage 3 de l'aéronef est assurée à travers ledit moyen de support 4.

## Revendications

1. Ensemble de connexion (1) d'au moins un équipement électronique (2) au câblage (3) d'un aéronef, dans lequel ledit au moins un équipement électronique (2) est disposé dans un moyen de support (4) et comporte des moyens de connexion aptes à être raccordés au câblage (3) de l'aéronef par l'intermédiaire d'au moins une interface de connexion (6), ladite au moins une interface de connexion (6) étant raccordée au câblage (3) par l'intermédiaire d'un boîtier de câblage (30) interposé entre ladite interface (6) et le câblage (3), ledit boîtier de câblage (30) étant disposé dans le moyen de support (4) pour assurer la connexion entre l'interface de connexion (6) et le câblage (3) à travers ledit moyen de support (4), le moyen de support (4) comportant une face avant (16) et une face arrière (18) au niveau de laquelle est disposée ladite au moins une interface de connexion (6),
**caractérisé en ce que**
l'ensemble de connexion (1) repose sur une surface et comporte un caisson (31) dans lequel est disposé le câblage (3) et qui s'étend au voisinage de la face avant (16) du moyen de support, le caisson (31) étant disposé au-dessus d'une ouverture (27) pratiquée dans ladite surface et le câblage (3) traversant ladite ouverture pour pénétrer dans le caisson (31),
**en ce que** ladite au moins une interface de connexion (6) est fixée à la structure de l'aéronef, et
**en ce que** des moyens de guidage (17,43,44) sont disposés sur la structure de l'aéronef pour guider le moyen de support (4) en regard de l'interface de connexion (6).

2. Ensemble de connexion selon la revendication 1, **caractérisé en ce que** le moyen de support (4) comporte au moins un module (8) de section sensiblement rectangulaire, dont le fond est en regard de l'interface de connexion (6), et dont la face avant (16) est ouverte, ledit au moins un équipement électronique (2) et le boîtier de câblage (30) étant adaptés pour être insérés dans ledit au moins un module (8).

3. Ensemble de connexion selon la revendication 2, **caractérisé en ce que** ledit au moins un module (8) est adapté pour recevoir au moins un équipement électronique (2) et un unique boîtier de câblage (30).

4. Ensemble de connexion selon la revendication 2 ou 3, **caractérisé en ce que** le boîtier de câblage (30) est raccordé par une extrémité au câblage (3) de l'aéronef au voisinage de la face avant (16) dudit au moins un module (8), l'extrémité opposée dudit boîtier de câblage (30) étant connectée dans le fond dudit au moins un module (8) à ladite au moins une interface de connexion (6).

5. Ensemble de connexion selon l'une des revendications 2 à 4, **caractérisé en ce que** le moyen de support (4) comporte plusieurs modules (8) disposés les uns au dessus des autres.

6. Ensemble de connexion selon l'une des revendications précédentes, **caractérisé en ce que** ladite au moins une interface de connexion (6) est intégrée au moyen de support (4).

7. Ensemble de connexion selon la revendication 1, **caractérisé en ce que** le câblage est disposé à la verticale, le caisson s'étendant verticalement.

8. Ensemble de connexion selon la revendication 1 ou 7, **caractérisé en ce que** le caisson est pourvu de trous disposés de façon à ce que les câbles ou faisceaux de câbles constituant le câblage (3) ressortent dudit caisson à travers lesdits trous en vue de leur raccordement à au moins un boîtier de câblage.

9. Ensemble de connexion selon l'une des revendications 1 à 8 , **caractérisé en ce que** deux moyens de support (4) sont disposés côte à côte, un unique passage de câbles (31) s'étendant au voisinage des deux moyens de support (4).

10. Aéronef **caractérisé en ce qu'**il comporte au moins un ensemble de connexion d'un équipement électronique selon l'une des revendications 1 à 9.

## Patentansprüche

1. Anschlusseinheit (1) zum Anschluss mindestens einer elektronischen Einrichtung (2) an die Verkabelung (3) eines Luftfahrzeugs, wobei die mindestens eine elektronische Einrichtung (2) in einem Haltemittel (4) angeordnet ist und Verbindungsmittel aufweist, die geeignet sind, an die Verkabelung (3) des Luftfahrzeugs über mindestens eine Verbindungsschnittstelle (6) angeschlossen zu werden, wobei die mindestens eine Verbindungsschnittstelle (6) an die Verkabelung (3) über ein Verkabelungsgehäuse (30) angeschlossen ist, das zwischen der Schnittstelle (6) und der Verkabelung (3) angeordnet ist, wobei das Verkabelungsgehäuse (30) in dem Haltemittel (4) angeordnet ist, um die Verbindung zwischen der Verbindungsschnittstelle (6) und der Verkabelung (3) durch das Haltemittel (4) hindurch sicherzustellen, wobei das Haltemittel (4) eine Vorderseite (16) und eine Rückseite (18), an der die mindestens eine Verbindungsschnittstelle (6) angeordnet ist, aufweist,
**dadurch gekennzeichnet, dass**
die Anschlusseinheit (1) auf einer Fläche ruht und einen Kasten (31) aufweist, in welchem die Verkabelung (3) angeordnet ist und welche sich in der Nähe der Vorderseite (16) des Haltemittels erstreckt, wobei der Kasten (31) oberhalb einer Öffnung (27) angeordnet ist, die in der Fläche ausgebildet ist, und die Verkabelung (3) die Öffnung durchquert, um in den Kasten (31) hineinzuführen, dadurch, dass die mindestens eine Verbindungsschnittstelle (6) an der Struktur des Luftfahrzeugs befestigt ist, und
dadurch, dass Führungsmittel (17, 43, 44) an der Struktur des Luftfahrzeugs angeordnet sind, um das Haltemittel (4) gegenüber der Verbindungsschnittstelle (6) zu führen.

2. Anschlusseinheit nach Anspruch 1, **dadurch gekennzeichnet, dass** das Haltemittel (4) mindestens ein Modul (8) mit im Wesentlichen rechteckigem Querschnitt aufweist, dessen Boden sich gegenüber der Verbindungsschnittstelle (6) befindet und dessen Vorderseite (16) offen ist, wobei die mindestens eine elektronische Einrichtung (2) und das Verkabelungsgehäuse (30) dafür ausgelegt sind, in das mindestens eine Modul (8) eingesetzt zu werden.

3. Anschlusseinheit nach Anspruch 2, **dadurch gekennzeichnet, dass** das mindestens eine Modul (8) dafür ausgelegt ist, mindestens eine elektronische Einrichtung (2) und ein einziges Verkabelungsgehäuse (30) aufzunehmen.

4. Anschlusseinheit nach Anspruch 2 oder 3, **dadurch gekennzeichnet, dass** das Verkabelungsgehäuse (30) mit einem Ende in der Nähe der Vorderseite (16) des mindestens einen Moduls (8) an die Verkabelung (3) des Luftfahrzeugs angeschlossen ist, wobei das entgegengesetzte Ende des Verkabelungsgehäuses (30) im Boden des mindestens einen Moduls (8) mit der mindestens einen Verbindungsschnittstelle (6) verbunden ist.

5. Anschlusseinheit nach einem der Ansprüche 2 bis 4, **dadurch gekennzeichnet, dass** das Haltemittel (4) mehrere Module (8) aufweist, die übereinander angeordnet sind.

6. Anschlusseinheit nach einem der vorhergehenden Ansprüche, **dadurch gekennzeichnet, dass** die mindestens eine Verbindungsschnittstelle (6) in das Haltemittel (4) integriert ist.

7. Anschlusseinheit nach Anspruch 1, **dadurch gekennzeichnet, dass** die Verkabelung vertikal angeordnet ist, wobei sich der Kasten vertikal erstreckt.

8. Anschlusseinheit nach Anspruch 1 oder 7, **dadurch gekennzeichnet, dass** der Kasten mit Löchern versehen ist, die derart angeordnet sind, dass die Kabel oder Kabelbäume, welche die Verkabelung (3) bilden, zu ihrem Anschluss an mindestens ein Verkabelungsgehäuse durch die Löcher hindurch aus dem Kasten hinausführen.

9. Anschlusseinheit nach einem der Ansprüche 1 bis 8, **dadurch gekennzeichnet, dass** zwei Haltemittel (4) nebeneinander angeordnet sind, wobei sich ein einziger Kabeldurchgang (31) in der Nähe der zwei Haltemittel (4) erstreckt.

10. Luftfahrzeug, **dadurch gekennzeichnet, dass** es mindestens eine Anschlusseinheit zum Anschluss einer elektronischen Einrichtung nach einem der Ansprüche 1 bis 9 aufweist.

## Claims

1. Connection assembly (1) for at least one item of electronic equipment (2) to the wiring (3) of an aircraft, in which the said at least one item of electronic equipment (2) is disposed in a support means (4) and comprises connection means able to be connected to the wiring (3) of the aircraft through at least one connection interface (6), the said at least one connection interface (6) being connected to the wiring (3) through a wiring box (30) interposed between the said interface (6) and the wiring (3), the said wiring box (30) being disposed in the support means (4) to provide the connection between the connection interface (6) and the wiring (3) through the said support means (4), the support means (4) comprising a front face (16) and a rear face (18) on which there is disposed at least one connection interface (6), **characterized in that** the connection assembly (1) rests on a surface and comprises a box (31) in which the wiring (3) is disposed and which extends to the vicinity of the front face (16) of the support means, the box (31) being disposed above an opening (27) made in said surface and the wiring (3) passing through said opening in order to enter the box (31), **in that** said at least one connection interface (6) is attached to the structure of the aircraft, and **in that** guide means (17, 43, 44) are disposed on the structure of the aircraft in order to guide the support means (4) opposite the connection interface (6).

2. Connection assembly according to claim 1, **characterized in that** the support means (4) comprises at least one module (8) with more or less rectangular section, the back of which is opposite the connection interface (6), and the front face (16) of which is open, the said at least one item of electronic equipment (2) and the wiring box (30) being adapted for being inserted into the said at least one module (8).

3. Connection assembly according to claim 2, **characterized in that** the said at least one module (8) is adapted for accommodating at least one item of electronic equipment (2) and a sole wiring box (30).

4. Connection assembly according to claim 2 or 3, **characterized in that** the wiring box (30) is connected by one end to the wiring (3) of the aircraft in the vicinity of the front face (16) of the said at least one module (8), the opposite end of the said wiring box (30) being connected in the back of the said at least one module (8) to the said at least one connection interface (6) .

5. Connection assembly according to one of claims 2 to 4, **characterized in that** the support means (4) comprises several modules (8) disposed one on top of the other.

6. Connection assembly according to one of the preceding claims, **characterized in that** the said at least one connection interface (6) is integrated into the support means (4).

7. Connection assembly according to claim 1, **characterized in that** the wiring is disposed vertically, the box extending vertically.

8. Connection assembly according to claim 1 or 7, **characterized in that** the box is provided with holes disposed so that the cables or cable bundles making up the wiring (3) emerge from the said box through the said holes with a view to their connection to at least one wiring box.

9. Connection assembly according to one of claims 1 to 8, **characterized in that** two support means (4) are disposed side by side, a sole cable passage (31) extending to the vicinity of the two support means (4).

10. Aircraft **characterized in that** it comprises at least one connection assembly for an item of electronic equipment according to one of claims 1 to 9.
